Europäisches Patentamt

European Patent Office

Office européen des brevets

(11) Publication number: **0 432 292 A1**

## EUROPEAN PATENT APPLICATION

(21) Application number: 89122930.4

(51) Int. Cl.⁵ **G01R 31/318**

(22) Date of filing: **12.12.89**

(43) Date of publication of application:
**19.06.91 Bulletin 91/25**

(84) Designated Contracting States:
**DE GB NL**

(71) Applicant: **ADVANTEST CORPORATION**
32-1, Asahi-cho 1-chome
Nerima-Ku Tokyo(JP)

(72) Inventor: **Kusama, Masaji**
1615-3, Wakakodama
Gyoda-shi Saitama(JP)

(74) Representative: **Blumbach Weser Bergen**
**Kramer Zwirner Hoffmann Patentanwälte**
**Radeckestrasse 43**
**W-8000 München 60(DE)**

(54) Logic IC tester.

(57) In logic IC tester for testing a logic IC by applying thereto test patterns successively read out of a pattern memory (12), a test processor (11) is connected via a tester bus (14) to a pattern memory readout controller (17e) and to a timing signal generator (25) and a formatter (21) whereby the test patterns read out of the pattern memory (12) are applied to the logic IC (23) under test under predetermined test conditions. The test processor (11) is further connected via a pattern transfer bus (34) to the pattern memory (12), and a write controller (17b) for controlling the write of the test patterns into the pattern memory is connected to the pattern transfer bus, whereby even if one logic IC is being tested, the test patterns can be transferred from the test processor to the pattern memory via the pattern transfer bus at any time when no test patterns are being read out of the pattern memory.

FIG. 3

## LOGIC IC TESTER

### BACKGROUND OF THE INVENTION

The present invention relates to a logic IC tester which provides test patterns to a logic IC and compares its response outputs with expected value patterns to test the logic IC.

In a conventional logic IC tester such, for example, as disclosed in U.S. Patent No. 4,497,056 each test pattern generated by a pattern generator is applied to an IC under test after being converted into a desired waveform of such a NRZ or RZ and then into an actual waveform of desired timing and amplitude, and the response output of the IC under test is compared with an expected value pattern. Each test pattern includes a pattern composed of a plurality of logic signals for simultaneous application to a plurality of input pins of the IC under test and an expected value pattern for comparison with response outputs from a plurality of output terminals of the IC under test.

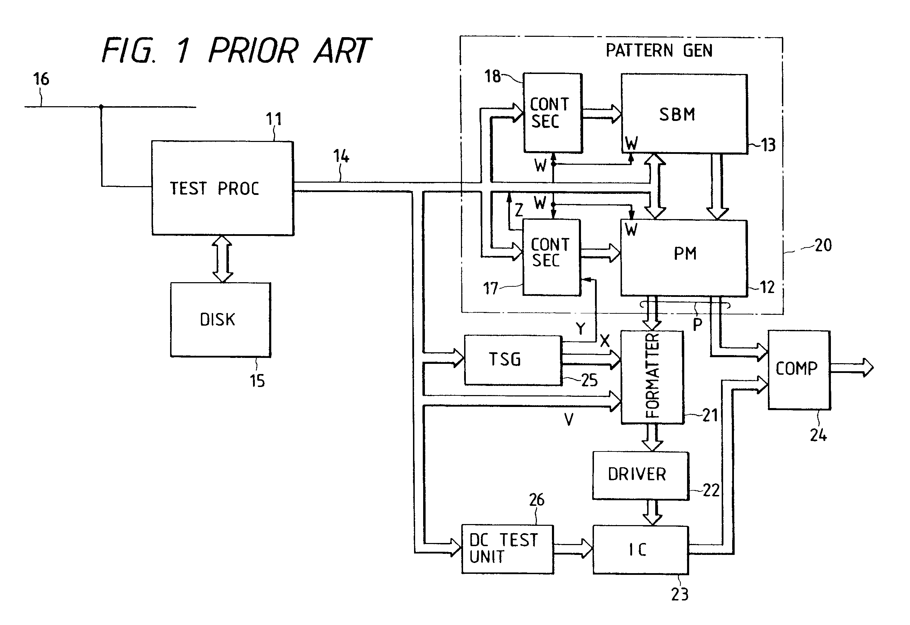

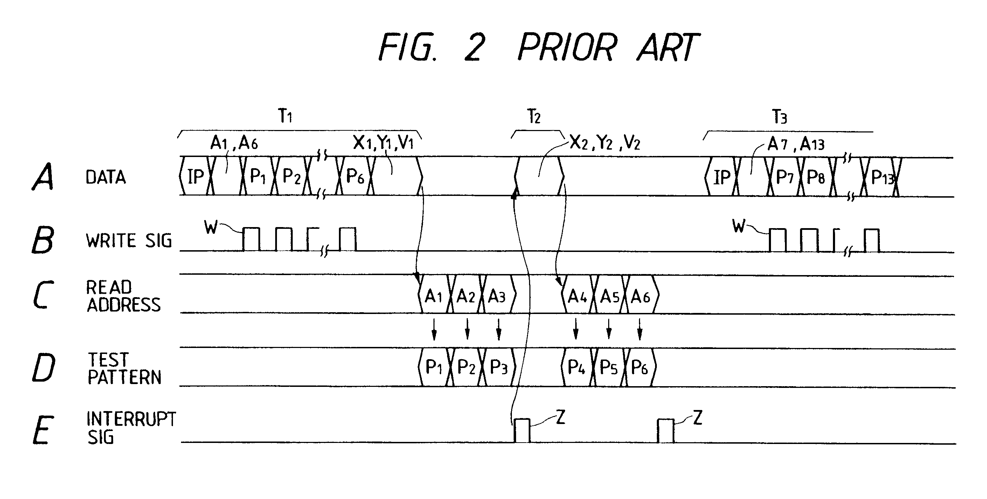

In the pattern generator, though its arrangement is not described in the above-mentioned U.S. patent, since test patterns for logic ICs have no regularity, they are prestored in a pattern memory, from which they are sequentially read out as the test proceeds. Such a pattern generator arrangement is shown in Figs. 2 and 11 of U.S. Patent No. 4,293,950, for instance. Fig. 1 schematically shows a combination of the known pattern generator with principal components of the logic IC tester disclosed in the first-mentioned U.S. patent. The equipment shown in Fig. 1 is adapted so that when all patterns necessary for testing one or more ICs cannot be stored in the pattern memory, the remaining patterns are stored in a so-called super buffer memory as required, which has a large memory capacity. Now, a description will be given, with reference to Fig. 1, the constitution of the conventional logic IC tester.

As depicted in Fig. 1, the logic IC tester includes: a test processor 11 formed by a computer, for running tests under program control; a pattern generator for generating test patterns in response to instructions of the test processor 11; a formatter which converts each test patterns to be applied to an IC under test 23 into a pattern of NRZ or NZ logical waveform and outputs it at desired timings; a driver 22 which converts the pattern from the formatter 21 into a pattern of an actual waveform of a predetermined level and applies it to the IC under test 23; a comparator which compares the response outputs from the IC under test 23 with an expected value pattern in the test pattern and determines whether or not the response outputs are correct logical outputs; a timing signal generator 25 which provides a period signal Y for determining the period of genration of the test patterns by the pattern generator 20 and a timing signal X for determining the pattern output timing of the formatter 21; a magnetic disk unit 15 for prestoring test patterns for various kinds of logic ICs, instruction programs for controlling the procedure of generating the test patterns, and data for setting conditions for the test patterns; and, if necessary, a DC test unit for making DC tests of the logic ICs. The pattern generator 20 includes a pattern memory 12, a super buffer memory 13, and control sections 17 and 18 for controlling their write and read.

The test processor 11 includes a RAM which has stored therein a test program, a RAM which has stored therein an instruction program and setting data for test read out of the magnetic disk unit 15 in accordance with the kind of the IC under test under control of the test program, and a CPU for controlling the running of the test in accordance with the test program. These components are well-known in the art, and hence they are not shown nor will they be described in detail. The test processor 11 is connected via an input/output interface (not shown) to the control sections 17 and 18, the pattern memory 12 and the super buffer memory 13 in the pattern generator 20 by a tester bus 14. Prior to the start of the test of the logic IC 23, an instruction program IP for controlling the procedure for reading test patterns out of the pattern memory 12 is loaded into an instruction memory (not shown) in the control section 17, a start address and a stop address are initialized in the control sedction 17, and then a sequence of patterns necessary for the test are successively read out of the magnetic disk unit 15 or an external network 16 and transferred into an area of the pattern memory 12 specified by the start address and the stop address. The large-capacity super buffer memory 13 can be read at a higher rate than the disk unit 15, so that when all the test patterns cannot be accommodated in the pattern memory 12, the remaining patterns are written into the super buffer memory 13 in an area specified by the start and stop addresses, and as the test proceeds, when all the patterns written into the pattern memory 12 have been read out therefrom, the succeeding patterns are transferred from the super buffer memory 13 to the pattern memory 12 at a high transfer rate, and then the test is resumed. A sequence of patterns for the next test may be prestored in either of the pattern memory 12 and the super buffer memory 13, if their capacity is large enough to do so. The write of test patterns into the memories 12 and 13 is effected upon each application thereto of a write signal W from the test processor 11 via one of control lines in the tester bus 14.

For the generation of test patterns from the pattern generator 20, read addresses generated by the control section 17 are provided to the pattern memory 12 in synchronism with the period signal Y from the timing signal generator 25, by which the test patterns are successively read out of specified addresses of the pattern memory 12. The control section 17 includes an instruction memory into which an instruction program for controlling the read address generation, i.e. the pattern generation, is preloaded from the test processor 11, and a program counter for controlling the readout of the instruction memory. No description will be given of them, because a similar arrangement is disclosed in the afore-mentioned U.S. Patent No. 4,293,950.

A plurality of logic signals, which form each of the test patterns generated by the pattern generator 20 which are to be applied in parallel to all input terminals of the IC under test 23, are each converted into a preset NRZ (Non-Return-to-Zero) or RZ (Return-to-Zero) logic waveform, thereafter being output at timing (in a phase) specified by a timing signal X which is produced by the timing signal generator 25. These logic waveforms are converted by the driver 22 into patterns of actual waveforms of desired levels, which are applied to the input terminals of the IC under test 23. The response outputs from output terminals of the IC under test 23 are each compared by the comparator 24 with the corresponding values of the expected value pattern in the test pattern to detect coincidence or noncoincidence between each expected value and the corresponding logic waveform, and the results of comparison are stored in a memory (not shown). Provision is made for the DC test unit 26 to make a DC test of the logic IC, as required, such as measurement of current flowing through the IC in response to the voltage applied to its input terminals or measurement of ON and OFF voltages at its output terminals.

Fig. 2 is a timing chart of operation of the conventional test equipment shown in Fig. 1. A test of one logic IC is made usually with a sequence of test patterns $P_1$ through $P_6$ as depicted in Fig. 2D, for instance, and the kind of the logic waveform (NRZ, NZ) of the patterns which are applied to the IC under test 23 and/or their phases are changed every one or more patterns as required. In the example shown in Fig. 2D the formatter 21 sets the logic waveforms and their timings every three patterns.

Prior to the test of the IC 23, the test processor 11 performs the following initializations via the tester bus 14 in a period $T_1$ shown in line A of Fig. 2. First, it loads an instruction programs IP for pattern generation into an instruction memory (not shown) in the control section 17; second, it sets in a register in the control section 17 start and stop addresses $A_1$ and $A_6$ specifying an area of the pattern memory 12 into which the test patterns $P_1$ through $P_6$ are to be written; third, it reads out the patterns $P_1$ through $P_6$ from the disk unit 15 and sequentially writes them into the pattern memory 12 by write signals W shown in line B of Fig. 2; fourth, it sets in the timing signal generator 25 a value $Y_1$ specifying the period of the period signal Y and a value $X_1$ specifying the phase of the timing signal X which are both generated by the timing signal generator 25; finally, it sets in the formatter 21 a value $V_1$ specifying the logic waveform which is selected by the formatter 21. These data IP, $A_1$, $A_6$, $P_1$ through $P_6$, $Y_1$, $X_1$ and $V_1$ are all transferred via the tester bus 14.

The control section 17 generates, in synchronism with the timing signal Y, read addresses $A_1$, $A_2$ and $A_3$ shown in line C of Fig. 2 and provides them to the pattern memory 12, from which the test patterns $P_1$, $P_2$ and $P_3$ shown in line D of Fig. 2 are read out one after another for running such a logical test as mentioned previously. After generating the addresses $A_1$, $A_2$ and $A_3$ for reading out the test patterns $P_1$, $P_2$ and $P_3$, the control section 17 temporarily suspends the address generation pursuant to the instruction program and sends to the test processor 11 an interrupt signal Z shown in line E of Fig. 2. Upon receipt of the interrupt signal Z the test processor 11 transfers, in a period $T_2$, set values $X_2$, $Y_2$ and $V_2$ for the next test patterns $P_4$, $P_5$ and $P_6$ to the timing signal generator 25 and the formatter 21 via the tester bus 14. Based on these set values, the test patterns $P_4$, $P_5$ and $P_6$ are generated, which are used to make the logical test of the IC 23. In this way, the setting of the data and the generation of the test patterns are repeated, and upon completion of the logical test by the last test pattern $P_6$, the test processor 11 receives the interrupt signal Z from the control section 17, completing a series of tests of the IC 23. Incidentally, the period $T_2$ is selected not only for setting the data $X_2$, $Y_2$ and $V_2$ but also for a DC test by the DC test unit 26. Accordingly, the period $T_2$ is set to be a predetermined sufficiently large value in anticipation of an excess response of the IC under test 23 in the DC test.

Upon completion of its test the IC 23 is automatically exchanged for the next IC, which is then subjected to the logical test. When the IC 23 to be tested next is different in kind from the IC tested previously, a sequence of test patterns, for example, $P_7$ through $P_{13}$ different from those for the previous test are needed, and consequently, it is necessary to transfer the test patterns from the disk unit 15 to the pattern memory 12 in a period $T_3$ shown in line A of Fig. 2. The number of test patterns actually used for testing one logic IC is as large as several hundreds to tens of thousands, so that their transfer to the pattern memory 12 via the tester bus 14 is time-consuming. In the case of testing various kinds of ICs by the conventional IC tester depicted in Fig. 1, a sequence of test patterns must be transferred for each kind, during which no test of the IC can be run, so that the number of logic ICs which can be tested per unit time is small as a whole, and consequently, the prior art IC tester has a defect of a low test throughput.

## SUMMARY OF THE INVENTION

It is therefore an object of the present invention to provide a logic IC tester which allows a transfer of test patterns to the pattern memory even during testing of an IC, and hence permits efficient testing of a large number of ICs with a high throughput.

According to the present invention, the test processor and the pattern memory are interconnected via a pattern transfer bus and the write of test patterns into the pattern memory is effected under control of write control means connected to the pattern transfer bus. The test patterns are read out of the pattern memory under control of read control means connected to a data bus. Consequently, in the course of testing a logic IC, test patterns for the next test can be transferred to an idle area of the pattern memory via the pattern transfer bus.

## BRIEF DESCRIPTION OF THE DRAWINGS

Fig. 1 is a block diagram showing a conventional logic IC tester;
Fig. 2 is a timing chart for explaining the operation of the logic IC tester depicted in Fig. 1;
Fig. 3 is a block diagram illustrating the logic IC tester of the present invention; and
Fig. 4 is a timing chart for explaining the operation of the logic IC tester shown in Fig. 3.

## DESCRIPTION OF THE PREFERRED EMBODIMENTS

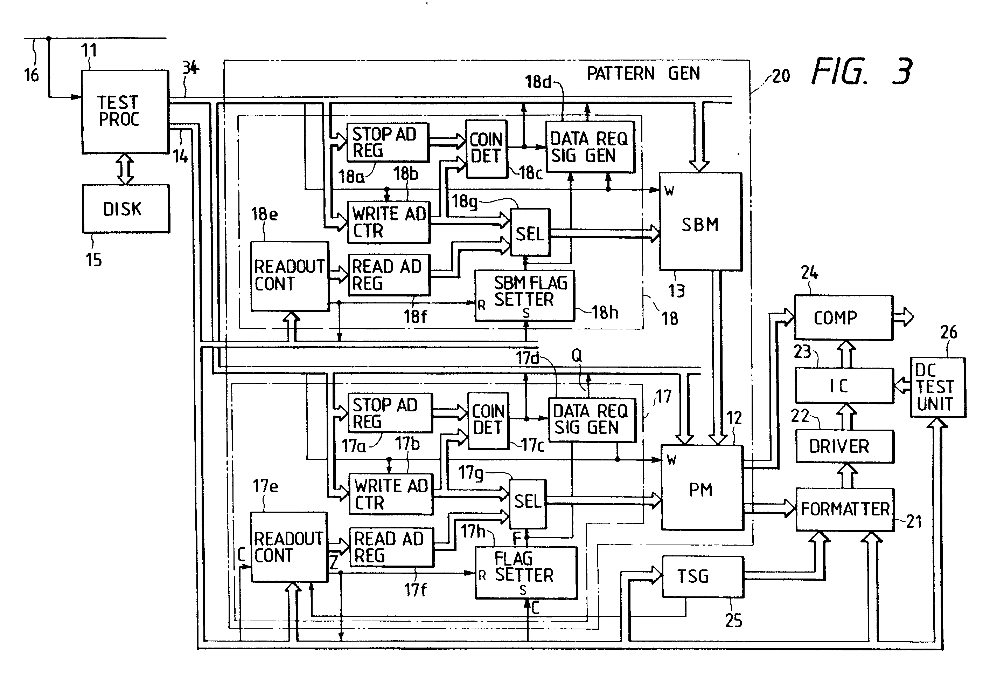

Fig. 3 illustrates in block form an embodiment of the logic IC tester according to the present invention, which is identical with the prior art example of Fig. 1 in the provision of the test processor 11, the tester bus 14, the magnetic disk unit 15, the pattern generator 20, the formatter 21, the driver 22, the timing signal generator 25 and the DC test unit 26 and in the provision of the pattern memory 12, the super buffer memory 13 and the control sections 17 and 18 in the pattern generator 20. This embodiment differs from the prior art example in that a pattern transfer bus 34 is provided through which test patterns can be transferred from the magnetic disk unit 15 (or the external network 16) to the pattern memory 12 and the super buffer memory 13. As will be described later, the control sections 17 and 18 effect the write into the memories 12 and 13 based on data sent from the test processor 11 via the pattern transfer bus 34 and effect the readout of the memories 12 and 13 based on data sent from the test processor 11 via the conventional tester bus 14.

As depicted in Fig. 3, the control section 17 includes a stop address counter 17a and a write address counter 17b connected to the pattern transfer bus 34, a coincidence detector 17c connected to them, and a data request signal generator 17d, by which the write of test patterns into the pattern memory 12 is controlled. The control section 17 further includes a readout controller 17e connected to the tester bus 14, for generating read addresses, and a read address register 17f in which the read addresses generated by the readout controller 17e are set one after another. The readout controller 17e and the read address register 17f control the readout of test patterns from the pattern memory 12, that is, the generation of test patterns. Moreover, the control section 17 includes a selector 17g which selectively provides to the pattern memory 12 either one of the write and read addresses from the write address counter 17b and read address register 17f, and a flag setter 17h in which a flag is set by a pattern generation start command signal C provided from the test processor 11 via the tester bus 14 and is reset by the interrupt signal Z which is produced by the readout controller 17e when suspending the address generation.

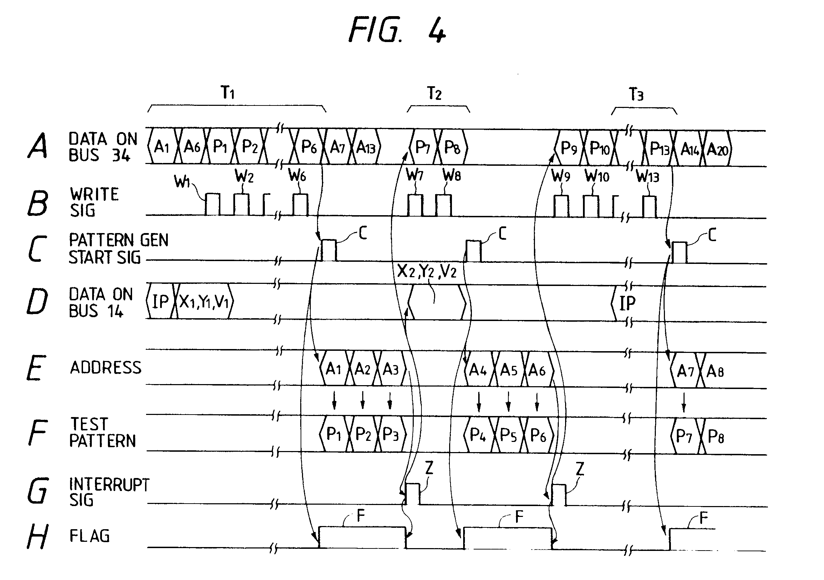

Next, a description will be given, with reference to Fig. 4, of the transfer of test patterns to the pattern memory 12 and the readout of test patterns therefrom.

Prior to the test of the IC 23, as shown in line A of Fig. 4, the test processor 11 initializes via the pattern transfer bus 34 the write start address $A_1$ and the write stop address $A_6$ for the pattern memory 12 in the write address counter 17b and the stop address register 17a, respectively, and generates a pattern transfer start signal as a first write signal $W_1$ and, at the same time, sends the test pattern $P_1$ from the disk unit 15 onto the pattern transfer bus 34. The flag register 17h has its output F initialized to an L level, and by the L-level output F the selector 17g selects the output of the write address counter 17b. Consequently, the test pattern $P_1$ is written into an address $A_1$ of the pattern memory 12 by the write signal $W_1$. The coincidence detector 17c compares the contents of the stop address register 17a (having set therein the stop address $A_6$) and the write address counter 17b and yields an L-level output in the case of noncoincidence and an H-level output in the case of coincidence. Since the current content of the write address counter 17b is $A_1$, the output of the coincidence detector 17c is L-level. The data request signal generator 17d responds to the write signal W to output a data request signal Q when the output of the coincidence detector 17c is L-level and, at the same time, the output flag signal F of the flag setter 17h is L-level, and the data request signal Q is sent to the test processor 11 via the pattern transfer bus 34. The write address counter 17b is incremented by the fall of the write signal $W_1$ applied thereto.

Upon each reception of the data request signal Q via the data transfer bus 34, the test processor 11 generates the write signal W as indicated by $W_2$, $W_3$, ... in line B of Fig. 4. When the write signal $W_5$ is produced, the data request signal generator 17d responds thereto to yield the last data request signal Q and the contents of the write address counter 17b become $A_6$ by the fall of the write signal $W_5$ and then the coincidence detector 18c yields the H-level output. Consequently, the test processor 11 responds to the last data request signal Q to transfer the last test pattern $P_6$ and output the last write signal $W_6$, by which the test pattern $P_6$ is written into the address $A_6$ of the pattern memory 12.

During the above test pattern transfer the test processor 11 reads out and loads the instruction program IP into the controller 17c and sets the timing signal data $X_1$ and the period data $Y_1$ in the timing signal generator 25 and the logical waveform data $V_1$ in the formatter 21 via the tester bus 14 as shown in line D of Fig. 4. Upon completion of the above-mentioned test pattern transfer, the test processor 11 generates the pattern generation start signal C as depicted in line C of Fig. 4, by which a flag is set in the flag setter 17h, that is, the flag signal F is made H-level as depicted in line H of Fig. 4. As a result of this, the selector 17g selects the output of the read address register 17f and supplies it as a read address to the pattern memory 12. Further, in order to transfer a sequence of test patterns $P_7$ to $P_{13}$ for the next IC, the test processor 11 sets via the pattern transfer bus 34 a write start address $A_7$ and a write stop address $A_{13}$, which specify an idle area of the pattern memory 12 into which the test patterns are to be written, in the write address counter 17b and the stop address register 17a, respectively, at the same time as the pattern generation start signal C is produced. The pattern generation start signal C is provided as well to the readout controller 17e to cause it to start the generation of read addresses under control of the instruction program. The addresses $A_1$, $A_2$, $A_3$ produced by the readout controller 17e, shown in line E of Fig. 4, are sequentially set in the read address register 17f. from which they are provided via the selector 17g to the pattern memory 12. By these addresses the test patterns $P_1$, $P_2$ and $P_3$ shown in line F of Fig. 4 are sequentially read out and provided via the formatter 21 and the driver 22 to the IC under test 23 for its logical test.

Upon completion of generating the read addresses $A_1$, $A_2$ and $A_3$ under control of the instruction program, the readout controller 17e temporarily stops the address generation and yields the interrupt signal Z depicted in line G of Fig. 4. By the interrupt signal Z the flag setter 17h is rest to make its output flag signal F L-level as shown in line H of Fig. 4. As a result of this, the selector 17g selects again the output of the write address counter 17b and provides it as a write address to the pattern memory 12. The interrupt signal Z is sent via the tester bus 14 to the test processor 11. The test processor 11 responds to the interrupt signal Z to start the transfer of the test patterns $P_7$ through $P_{13}$ for the second IC under test 23 from the disk unit 15 to the pattern memory 12 via the pattern transfer bus 34 and, at the same time, sends out the write signal W. In consequence, as many test patterns as possible are written into the pattern memory 12 by the write signal W in the fixed period $T_2$. In this example the test patterns $P_7$ and $P_8$ are written into addresses $A_7$ and $A_8$ of the pattern memory 12 by the write signals $W_7$ and $W_8$ in the period $T_2$. On the other hand, the test processor 11 responds to the interrupt signal Z to set in the timing signal generator 25 and the formatter 21 via the tester bus 14 data $X_2$, $Y_2$ and $V_2$ for the next test patterns $P_4$, $P_5$ and $P_6$ which are provided to the IC 23 currently under test in the period $T_2$.

When the period $T_2$ ends, the test processor 11 produces again the pattern generation start signal C, which is applied to the flag setter 17h to set a flag. The pattern generation start signal C is applied also to the readout controller 17e to cause it to resume the address generation. The readout controller 17e generates addresses $A_4$, $A_5$ and $A_6$ as shown in line E of Fig. 4, which are provided to the pattern memory 12, reading out therefrom the test patterns $P_4$, $P_5$ and $P_6$ as shown in line F of Fig. 4. Having generated the last address $A_6$ of the addresses $A_1$ through $A_6$ for generating the complete sequence of test patterns $P_1$ through $P_6$ for the IC 23 currently under test, the readout controller 17e produces the interrupt signal Z, by which the flag setter 17h is reset, causing the test processor 11 to resume the transfer of the test patterns for the IC to be tested next. As a result of this, the test patterns $P_9$ through $P_{13}$ are successively written via the pattern transfer bus 34 into the pattern memory 12 at its addresses $A_9$ through $A_{13}$ by

write signals $W_9$ through $W_{13}$. A certain elapsed time after having responded to the last interrupt signal Z, the test processor 11 changes the tested logic IC 23 for the next one and loads a pattern generating instruction program therefor into the readout controller 17e via the tester bus 14. Thereafter the test patterns $P_7$ through $P_{13}$ for the second logic IC 23 (assumed to be different in type from the first one) are generated in the same manner as described above. The transfer of test patterns from the disk unit 15 to the pattern memory 12 is effected by the known DMA (i.e. direct memory access) method.

As will be appreciated from the above description given with reference to Figs. 3 and 4, according to the present invention, the transfer of test patterns from the test processor 11 to the pattern memory 12 is made via the pattern transfer bus 34 by the write control means 17a through 17d connected thereto, whereas the readout of test patterns from the pattern memory 12 is made via the tester bus 14 by the readout control means 17e and 17f connected thereto. Consequently, even while the IC 23 is being under test, test patterns can be transferred from the test processor 11 to the pattern memory 12 any time when test patterns are not being read out of the pattern memory 12. In addition, the start and stop addresses for specifying a write area in the pattern memory 12 can be set via the pattern transfer bus 34 even in the course of the readout of test patterns from the pattern memory 12 (in the time interval between the periods $T_1$ and $T_2$ in Fig. 4, for example). Thus the present invention achieves high throughput in testing a large number of logic ICs of different kinds.

In Fig. 3 the control section 18 for the super buffer memory 13 has about the same construction as the afore-mentioned control section 17. The control section 18 includes a stop address register 18a and a write address counter 18b connected to the pattern transfer bus 34, a coincidence detector 18c for detecting coincidence between their contents, and a data request signal generator 18d. The control section 18 further includes a readout controller 18e connected to the tester bus 14, a read address register 18f for setting therein a read address generated by the readout controller 18e, a selector 18g for selectively providing the contents of either one of the write address counter 18b and the read address register 18f to the super buffer memory 13, and a flag setter 18h for specifying which one of them is to be selected by the selector 18g.

Since complicated control such as for reading out test patterns from the pattern memory 12 is not needed, the readout control 18e may be of a simple construction including a stop address register, a write address counter and a coincidence detector, though not shown. This construction is obvious to those skilled in the art, and hence will not be described. The flag setter 18h is set by a super buffer read start signal which is provided thereto from the test processor 11 via the tester bus 14 and, is reset by an interrupt signal which is produced by the readout controller 18e upon completion of the read address generation. In other words, test patterns can be written into the super buffer memory 13 from the disk unit 15 via the pattern transfer bus 34 at any time except during the readout therefrom of test patterns (i.e. during the pattern transfer from the super buffer memory 13 to the pattern memory 12).

For the transfer of test patterns from the disk unit 15 to the super buffer memory 13 the test processor 11 specifies an area of the disk unit 15 from which the test patterns are to be read out, and sets, via the pattern transfer bus 34, in the write address counter 18b and the stop address register 18a start and stop addresses for defining an area of the super buffer memory 13 into which the test patterns are to be written. In this instance, the well-known DMA process is employed. Consequently, this pattern transfer can be continuously performed independently of the test of the logic IC 23 even if the test is being made.

The readout of test patterns from the super buffer memory 13 can be achieved at a higher rate than the readout of patterns from the disk unit 15, and the pattern transfer from the super buffer memory 13 to the pattern memory 12 can be effected at high speed after completion of the test of one logic IC. Where all test patterns necessary for testing one IC could not be loaded into the pattern memory 12 and the remaining test patterns have been written in the super buffer memory 13, all the test patterns written in the pattern memory 12 are read out and then immediately the succeeding test pattrens are transferred from the super buffer memory 13 to the pattern memory 12 at high speed, whereby the test can be resumed. The pattern transfer from the super buffer memory 13 to the pattern memory 12 is a known technique, and hence will not be described.

Although the above embodiment has been described in connection with the case where test patterns are transferred from the magnetic disk unit 15 to the pattern memory 12 or super buffer memory 13, it is also possible that test patterns supplied from the external network 16 are transferred to the pattern memory 12 or super buffer memory 13.

It will be apparent that many modifications and variations may be effected without departing from the scope of the novel concepts of the present invention.

## Claims

1. A logic IC tester comprising:
a test processor for controlling a test of a logic IC;
a pattern memory for storing test patterns;
a pattern transfer bus connected between said test processor and said pattern memory, for transferring said test patterns from said test processor to said pattern memory;
write control means connected to said pattern transfer bus, for controlling the transfer of said test patterns from said test processor to said pattern memory;
a tester bus connected to said test processor; and
read control means connected to said tester bus, for controlling the readout of said test patterns from said pattern memory.

2. The logic IC tester of claim 1 wherein said write control means includes: a write address counter which is connected to said pattern transfer bus and in which a write start address for said pattern memory is set from said test processor via said pattern transfer bus, said write address counter being incremented, step by step, by a write signal from said test processor; a stop address register which is connected to said pattern transfer bus and in which a write stop address for said pattern memory is set from said test processor via said pattern transfer bus; a coincidence detector for comparing the contents of said write address counter and said stop address register to detect coincidence therebetween; and a data request signal generator which, upon each application thereto of said write signal, sends a test pattern transfer request signal to said test processor via said pattern transfer bus until said coincidence detector detects coincidence, the content of said write address counter being provided as a write address to said pattern memory.

3. The logic IC tester of claim 2 wherein said read control means is a means for generating and providing a read address to said pattern memory under control of an instruction program loaded in said read control means from said test processor via said tester bus.

4. The logic IC tester of claim 3 further comprising: flag signal generating means connected to said tester bus, for outputting a flag signal during the readout of said test patterns from said pattern memory; and selector means for providing said read address from said read control means while said flag signal generating means is generating said flag signal and for providing the content of said write address counter as said write address to said pattern memory while said flag signal generating means does not generate said flag signal.

5. The logic IC tester of claim 1, 2, 3, or 4 further comprising: a super buffer memory connected to said pattern transfer bus, for storing test patterns transferred from said test processor via said pattern transfer bus, said test patterns stored therein being read out for supply to said pattern memory; second write control means connected to said pattern transfer bus, for controlling the transfer of said test patterns from said test processor to said super buffer memory; and second read control means connected to said tester bus, for controlling the readout of said test patterns from said super buffer memory.

6. The logic IC tester of claim 5 wherein said second write control means includes: a second write address counter which is connected to said pattern transfer bus and in which a write start address for said super buffer memory is set from said test processor via said pattern transfer bus, said second write address counter being incremented, step by step, by said write signal from said test processor; a second stop address register which is connected to said pattern transfer bus and in which a write stop address for said super buffer memory is set from said test processor via said pattern transfer bus; a second coincidence detector for comparing the contents of said second write address counter and said second stop address register to detect coincidence therebetween; and a second data request signal generator which, upon each application thereto of said write signal, sends a test pattern transfer request signal to said test processor until said second coincidence detector detects coincidence, the content of said second write address counter being provided as a write address to said super buffer memory

7. The logic IC tester of claim 1, 2, 3, or 4 further comprising a magnetic disk unit which is connected to said test processor and from which said test processor reads out test patterns and transfers them via said pattern transfer bus to said pattern memory.

8. The logic IC tester of claim 5 further comprising a magnetic disk unit which is connected to said test processor and from which said test processor reads out test patterns and sends them out on said pattern transfer bus.

FIG. 1 PRIOR ART

PATTERN GEN

EP 0 432 292 A1

FIG. 2 PRIOR ART

EP 0 432 292 A1

# FIG. 3

**TEST PROC** 11

**DISK** 15

16

34

14

20 PATTERN GEN

**SBM** 13
W

18

STOP AD REG 18a
WRITE AD CTR 18b
READ AD REG
READOUT CONT 18e
COIN DET 18c
SEL 18g
DATA REQ SIG GEN 18d
SBM FLAG SETTER 18h
S R
18f

**PM** 12
W

17

STOP AD REG 17a
WRITE AD CTR 17b
READ AD REG 17f
READOUT CONT 17e
COIN DET 17c
SEL 17g
DATA REQ SIG GEN 17d
FLAG SETTER 17h
S R F C
Q
Z
C

**TSG** 25

**COMP** 24
**IC** 23
**DRIVER** 22
**FORMATTER** 21
**DC TEST UNIT** 26

10

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 727 312 (FULKS) * Column 4, line 57 - column 5, line 64; abstract * | 1,5 | G 01 R 31/318 |
| Y | | 2,6 | |
| Y | US-A-4 313 200 (NISHIURA) * Column 7, line 42 - column 8, line 15; abstract * | 2,6 | |
| A | PATENT ABSTRACTS OF JAPAN, vol. 10, no. 316 (P-510), 28th October 1986; & JP-A-61 126 480 (YOKOGAWA HOKUSHIN ELECTRIC CORP.) 13-06-1986 * Abstract * | 1,5 | |
| A | GB-A-2 108 278 (TERADYNE) * Abstract; page 1, lines 37-71; page 1, line 104 - page 2, line 30 * | 1,5 | |

TECHNICAL FIELDS
SEARCHED (Int. Cl.5)

G 06 F
G 01 R

The present search report has been drawn up for all claims

| Place of search | Date of completion of the search | Examiner |
|---|---|---|
| THE HAGUE | 23-07-1990 | SARASUA GARCIA L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)